# FASCICULE DE BREVET EUROPEEN

(11) **EP 3 482 219 B1**
(45) Date de publication et mention de la délivrance du brevet: **11.03.2026**
(21) Numéro de dépôt: 17737333.9
(22) Date de dépôt: 16.06.2017
(51) Int. Cl.: G01R 31/364, H01M 10/48, H01M 50/55, H01M 50/569, H01R 11/28, H01R 13/66, H01M 50/553

(54) **DISPOSITIF DE MESURE D'UN COURANT A SERRAGE VERTICAL SUR UNE BORNE DE BATTERIE**
VORRICHTUNG ZUM MESSEN EINES STROMES MIT VERTIKALER BEFESTIGUNG AN EINEM BATTERIEPOL
DEVICE FOR MEASURING A CURRENT, THE DEVICE BEING FASTENED VERTICALLY ONTO A BATTERY TERMINAL

(30) Priorité: 11.07.2016 FR 1656647
(43) Date de publication de la demande: 15.05.2019
(73) Titulaire: Ampere SAS, 92100 Boulogne-Billancourt (FR)
(72) Inventeur: BARROSO, Inaki, 78280 Guyancourt (FR); GUIGNARD, Fabrice, 78280 Guyancourt (FR)
(74) Mandataire: Renault Group
(86) Numéro de dépôt international: PCT/FR2017/051583
(87) Numéro de publication internationale: WO 2018/011481

(56) Documents cités:
- WO-A1-2011/001085
- DE-A1- 102004 055 848
- DE-A1- 102009 034 409
- DE-A1- 102012 211 701
- DE-A1- 102012 211 733
- DE-A1- 102012 211 749
- DE-A1- 102013 208 375
- DE-U1- 202013 005 113
- FR-A1- 2 910 719
- US-A1- 2011 050 240
- US-A1- 2013 252 050
- US-A1- 2014 327 444

## Description

La présente invention a trait à un dispositif électronique de mesure d'au moins un paramètre d'un courant électrique destiné à être monté sur une batterie de véhicule, notamment sur l'une de ses bornes. La présente invention a également trait à une batterie équipée d'un tel dispositif.

Il est connu du document EP2622690B1 de monter un dispositif électronique sur l'une des bornes d'une batterie de véhicule pour mesurer des paramètres notamment le courant entrant/sortant de cette batterie. Ce dispositif intègre différents éléments : une bride de serrage sur le plot de la batterie, un goujon de départ de la masse de la batterie, et une connectique pour transmettre un signal des valeurs mesurées. Ainsi le courant d'alimentation du véhicule circule entre la batterie et ce véhicule en traversant ce dispositif. Des composants électroniques intégrés à ce dernier permettent de prendre des mesures de ce courant et de les transmettre, par exemple à l'ordinateur de bord du véhicule. Ce dispositif est encore appelé capteur de courant. Ce capteur peut être dans un logement comprenant l'une des bornes de la batterie. Pour cela, la bride est emmanchée verticalement sur la borne. Une vis est agencée horizontalement et coopère avec un boulon pour rapprocher les brides et les serrer autour de la borne verticale de la batterie.

Un inconvénient d'un capteur de courant de ce type avec cette bride de serrage est qu'en serrant l'écrou autour de la vis horizontale, la bride a tendance à remonter vers le haut de la borne. Il s'ensuit qu'une fois le serrage complet, la bride risque d'être incomplètement engagée sur la borne. Ceci est d'autant plus gênant que la bride est conductrice et permet au courant de traverser le capteur.

Le document US 2011/0050240 A1 divulgue une pince de mesure de batterie intégrant une résistance de mesure et un circuit d'évaluation, destinée à surveiller l'état de charge de la batterie d'un véhicule. Néanmoins, la pince de mesure décrite dans US 2011/0050240 A1 présente une sécurité et une protection mécanique limitées du moyen d'actionnement du serrage, ce qui peut exposer la pince de mesure à des risques de dommages, de salissures ou de manipulations accidentelles.

Un problème que vise à résoudre l'invention est donc de rendre plus sûr le montage d'un dispositif électronique de mesure d'au moins un paramètre du courant sur la borne d'une batterie de véhicule.

A cet effet, un premier objet de l'invention est un dispositif électronique de mesure d'au moins un paramètre d'un courant électrique destiné à être monté sur une batterie de véhicule, le dispositif électronique comprenant :
- une entrée d'alimentation électrique et une sortie d'alimentation électrique, l'entrée d'alimentation ou la sortie d'alimentation étant formée par un corps de serrage électriquement conducteur et conçu pour se resserrer autour d'un premier axe vertical par l'actionnement d'un moyen de serrage de manière à être apte à être serré autour d'une borne de batterie s'étendant selon une direction parallèle au premier axe,
- une sortie d'un signal portant des valeurs de mesure dudit au moins un paramètre d'un courant électrique circulant entre l'entrée d'alimentation et la sortie d'alimentation,
dans lequel le moyen de serrage est agencé de manière à pouvoir être actionné par un mouvement autour ou le long d'un deuxième axe sensiblement parallèle au premier axe, le moyen de serrage (20) comprenant un moyen d'actionnement du serrage (25), ledit dispositif électronique comprenant une enceinte de protection (30) avec une ou des parois de protection verticales (31) entourant le moyen d'actionnement du serrage (25) sur toute sa hauteur,
ladite enceinte de protection (30) comprend un capot supérieur (32) mobile entre une position de fermeture dans laquelle il est refermé au-dessus ou entre les parois de protection verticales, et une position ouverte dans laquelle il dégage l'accès entre ces parois verticales de protection.

Le fait que le dispositif électronique comprenne une enceinte de protection avec une ou des parois de protection verticales entourant le moyen d'actionnement du serrage sur toute sa hauteur permet d'éviter un branchement latéral sur le moyen de serrage.

Le fait que l'enceinte de protection comprenne un capot supérieur mobile entre une position de fermeture dans laquelle il est refermé au-dessus ou entre les parois de protection verticales, et une position ouverte dans laquelle il dégage l'accès entre ces parois verticales de protection permet d'éviter un branchement vertical sur le moyen de serrage.

L'agencement de ce moyen de serrage permet ainsi d'emmancher le moyen de serrage autour de l'une des bornes d'une batterie de véhicule, cette borne s'étendant selon une direction donnée, de sorte que le premier axe soit parallèle ou corresponde à cette direction, puis de serrer avec un outil, tel qu'une visseuse, le moyen de serrage autour de la borne, tout en maintenant avec cet outil le moyen de serrage enfoncé sur la borne. En effet, que ce soit en poussant selon le deuxième axe ou en tournant autour de celui-ci l'outil peut s'appuyer sur le corps de serrage. Le montage du dispositif selon l'invention est ainsi plus sûr.

Lorsqu'il est en place sur la batterie, comme le dispositif électronique de mesure est monté sur la batterie, cette dernière forme un support de ce dispositif électronique.

Selon l'invention, le dispositif électronique de mesure peut être agencé pour être uniquement supporté par la batterie, le seul moyen de fixation de ce dispositif à la batterie étant le moyen de serrage.

Selon l'invention, lorsque la batterie est en place dans le véhicule, le premier et le deuxième axes peuvent être verticaux.

Le dispositif électronique selon l'invention peut optionnellement présenter une ou plusieurs des caractéristiques suivantes :
- la sortie du signal est formée par un connecteur, ce connecteur étant décalé vers le haut par rapport à l'entrée d'alimentation et à la sortie d'alimentation ; cela permet une fois le dispositif électronique monté sur la batterie, et cette batterie montée dans le véhicule, de connecter plus aisément ce dispositif électronique à un câble, en passant ce câble au-dessus de la batterie ; ce décalage peut être notamment selon une direction sensiblement parallèle au premier axe ;
- le dispositif électronique comprend des bords latéraux circonscrits globalement dans un rectangle ; ainsi, le dispositif électronique peut être agencé de sorte que ledit dispositif électronique soit apte à être monté sur une borne d'une batterie de manière à ce qu'aucune portion du capteur de courant ne coupe des plans prolongeant vers le haut une face arrière et une face longitudinale de la batterie ; il est ainsi plus facile de le loger dans l'emplacement entourant les bornes de batterie ; on évite également un risque d'interférence du dispositif électronique avec les autres éléments du véhicule ; la face longitudinale peut être par exemple une face gauche de la batterie ;
- la sortie d'alimentation et la sortie du signal sont du même côté dudit rectangle ; de plus, le moyen de serrage, la sortie d'alimentation et la sortie du signal sont respectivement à un premier coin, à un deuxième coin et à un troisième coin du rectangle;
- le dispositif électronique comprend un logement de composants électroniques ;
- le logement de composants électroniques est dans un quatrième coin ;
- vu du côté où le moyen de serrage est actionnable, le moyen de serrage, la sortie d'alimentation, la sortie du signal, et le logement de composants électroniques sont répartis dans cet ordre autour du premier axe selon le sens inverse des aiguilles d'une montre ; ainsi il est possible de placer le dispositif électronique sur la borne négative située à gauche et à l'arrière de la batterie, une fois cette dernière montée dans le véhicule, en disposant la sortie d'alimentation le plus en arrière et à gauche possible, la sortie du signal le plus en arrière possible, et le moyen de serrage sur le côté de la batterie ;
- le moyen de serrage peut être un écrou monté sur un vis agencée selon le deuxième axe ;
- le corps de serrage comprend une bride en forme de U dans une section perpendiculaire au premier axe, cette forme en U comprenant une portion en arc de cercle et deux extrémités, la portion en arc de cercle définissant un passage destiné à s'emmancher sur l'une des bornes d'une batterie ; la bride forme un moyen simple d'enserrer une borne de batterie ;
- le moyen de serrage comprend une vis, un écrou monté sur la vis et une contreforme solidaire de la vis, la vis étant agencée selon le deuxième axe et passant entre les extrémités de la forme en U, et l'écrou et la contreforme étant agencés selon le deuxième axe de part et d'autre de ces extrémités, les extrémités et la contreforme présentant des formes complémentaires s'engageant l'une par rapport à l'autre de manière à ce qu'un effort de vissage sur l'écrou soit transféré en un effort perpendiculaire audit deuxième axe de manière à rapprocher les extrémités de le forme en U l'une de l'autre ; on forme ainsi un moyen simple de serrage autour du premier axe par un mouvement autour du deuxième axe ;
- la contreforme est une plaque comprenant des bords courbés et/ou repliés sensiblement parallèles au deuxième axe, les extrémités de la forme en U présentent des pans extérieurs obliques se rapprochant l'un de l'autre vers la plaque et se logeant entre lesdits bords courbés et/ou repliés ; c'est un moyen simple de renvoyer l'effort sensiblement perpendiculairement au deuxième axe ;
- le moyen de serrage comprend un passage pour une borne de batterie, l'actionnement en serrage du moyen de serrage réduisant ce passage, l'enceinte de protection passant au-dessus de ce passage ; ainsi on bloque également le branchement vertical sur la borne de la batterie ;

Un autre objet de l'invention est une batterie de véhicule comprenant un dispositif électronique selon l'invention, ce dispositif électronique étant monté sur cette batterie, le corps de serrage étant serré autour de l'une des bornes de la batterie, notamment la borne négative de cette dernière.

Ainsi, la batterie étant équipée du dispositif électronique de mesure du courant, est prête à l'emploi.

La batterie électronique selon l'invention peut optionnellement présenter une ou plusieurs des caractéristiques suivantes :
- le dispositif électronique est agencé de manière à ce que la sortie du signal soit sur le côté du dispositif électronique le plus proche d'une face arrière de la batterie ; cela permet de placer la batterie dans un véhicule avec un capot plongeant avec cette sortie au maximum à distance de ce capot ;
- le dispositif électronique est agencé de manière à ce que la sortie d'alimentation soit le plus proche du coin supérieur arrière gauche de la batterie par rapport au moyen de serrage, à la sortie du signal, et au logement de composants électroniques ; ainsi en étant au plus proche de ce coin, on facilite la connexion de cette sortie d'alimentation selon différentes directions ;
- la batterie comprend un espace encaissé à l'intérieur duquel est logée la borne de la batterie sur laquelle est monté le dispositif électronique, la sortie de signal étant agencée au-dessus de cet espace encaissé et formant l'élément le plus haut du dispositif électronique ; cela facilite la connexion de la sortie du signal en passant des câbles au-dessus de la batterie ;
- la sortie de signal est orientée vers l'avant, de manière à ce qu'un câble puisse être branché à l'avant de cette sortie ;
- la batterie comprend un coin supérieur arrière gauche défini par une face longitudinale, une face arrière et une face supérieure, le dispositif électronique étant agencé sur cette face supérieure et s'inscrivant complètement entre les plans prolongeant la face arrière et la face longitudinale au-dessus de la batterie ; on évite ainsi un risque d'interférence du dispositif électronique avec les autres éléments du véhicule ; la batterie s'adapte ainsi mieux à différents types de véhicules ; la face longitudinale est par exemple la face gauche.

Un autre objet de l'invention est un véhicule comprenant une batterie selon l'invention.

D'autres caractéristiques et avantages de l'invention apparaîtront à la lecture de la description détaillée des exemples non limitatifs qui suivent, pour la compréhension de laquelle on se reportera aux dessins annexés, parmi lesquels :
- la figure 1 est une vue en perspective d'une batterie selon l'invention, où l'on voit également un dispositif électronique selon un premier mode de réalisation de l'invention ;
- la figure 2 est un détail de la figure 1 ;
- la figure 3 est une vue en perspective, vue de dessus et depuis l'avant, du dispositif électronique de la figure 1, sans la batterie ;
- la figure 4 est une vue en perspective, vue de dessus et depuis l'avant, de la figure 3 mais sous un autre angle ;
- la figure 5 est une vue latérale gauche de la figure 3 ;
- la figure 6 est une vue de dessus de la figure 3, mais sans capot supérieur ;
- la figure 7 est une vue de dessus de la figure 1, avec un connecteur branché sur la sortie du signal ;
- la figure 8 est un schéma de principe de la connexion des éléments du dispositif électronique selon l'invention ;
- les figures 9 à 14 sont d'autres modes de réalisation du dispositif électronique selon l'invention.

Dans la présente demande, les termes « dessus », « supérieur », « haut », « dessous », « inférieur », « bas », « vertical », « longitudinal », « avant », « arrière », « transversal », « gauche » et « droite » sont utilisés par rapport à l'orientation dans laquelle la batterie et le dispositif électrique sont destinés à être montés dans le véhicule reposant avec ses roues sur un sol horizontal et selon un sens de conduite en marche avant.

Sur certaines de ces figures sont représentés les vecteurs X, Y, Z correspondant aux orientations respectivement longitudinale, transversale et verticale, que prennent la batterie et le dispositif électronique selon l'invention dans le véhicule. L'orientation longitudinale correspond à une orientation selon l'axe du véhicule, allant de l'arrière vers l'avant.

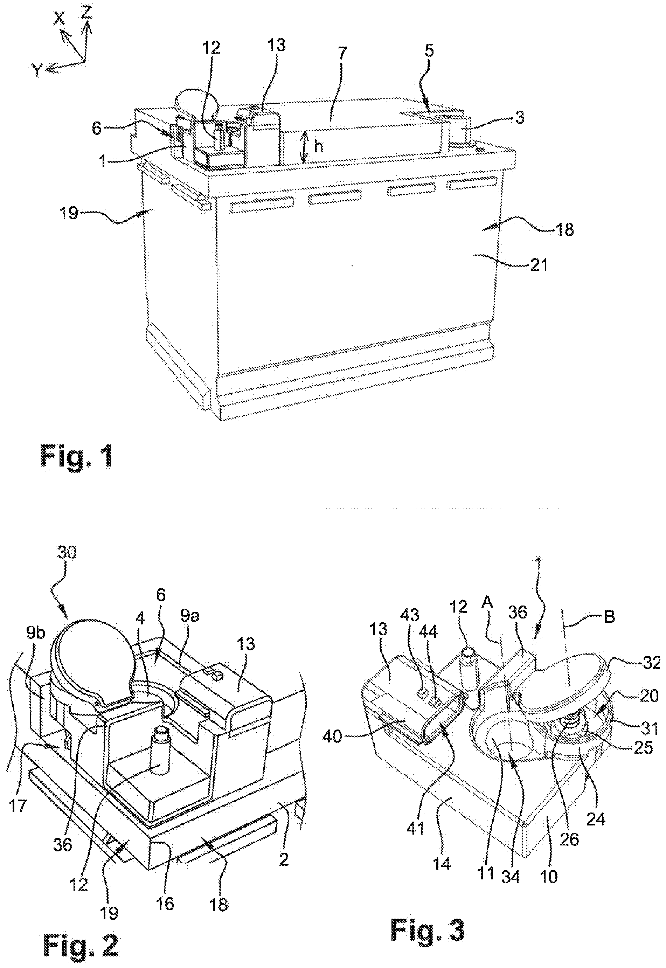

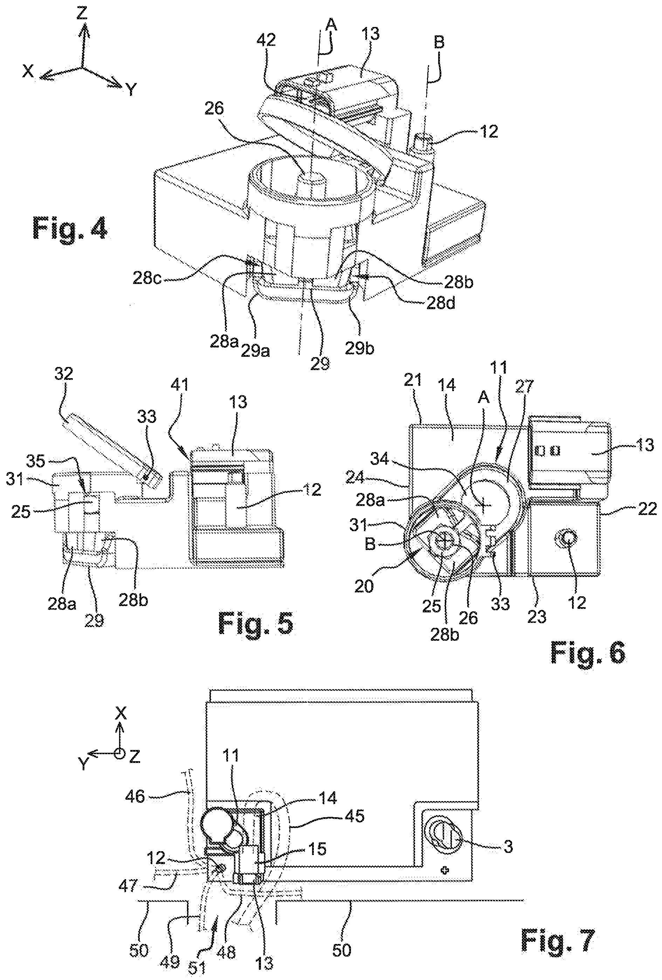

Les figures 1 et 2 illustrent une batterie 2 de véhicule comprenant un dispositif électronique 1 selon un exemple d'un premier mode de réalisation de l'invention. La figure 7 illustre la même vue mais avec un connecteur de réception du signal 15 branché au dispositif électronique, ainsi que des câbles et une partie du véhicule.

Le dispositif électronique 1 est monté sur cette batterie 2.

Le dispositif électronique 1 comprend un corps de serrage 11 serré autour de la borne négative 4 de la batterie 2 (visible en figure 7).

Le dispositif électronique est dans cet exemple un capteur de courant 1.

Ce capteur de courant 1 est illustré seul plus en détail en figures 3 à 6.

Le capteur de courant 1 comprend un passage 34 agencé autour d'un premier axe A et destiné à être emmanché sur la borne négative 4 de la batterie 2, comme on peut le voir en figures 1, 2 et 7. Ce premier axe est appelé ci-après axe d'emmanchement A.

Cette borne négative 4 s'étend selon une direction verticale. Une fois le capteur de courant 1 emmanché, l'axe d'emmanchement A est également vertical.

Le capteur de courant 1 comprend un corps de serrage 11 conducteur électrique qui comprend ce passage 34. Ce corps de serrage 11 est conçu pour se resserrer autour de l'axe d'emmanchement A par l'actionnement d'un moyen de serrage 20, donc autour de la borne négative 4.

Selon l'invention, ce corps de serrage 11 peut comprendre, comme dans cet exemple, une bride 27 en forme de U orienté horizontalement et comprenant une portion en arc de cercle définissant le passage 34 et des extrémités 28a et 28b.

Ces extrémités 28a et 28b peuvent présenter des pans extérieurs obliques 28c, 28d inclinés l'un vers l'autre en allant vers le bas, comme on peut le voir en figure 4. Le bas de ces extrémités 28a et 28b se loge entre les bords courbés verticaux 29a, 29b d'une plaque 29 de section en U, ce U étant orienté verticalement.

Le corps de serrage 11 comprend un moyen de serrage 20 formé par une vis 26, la plaque 29 et un écrou 25 vissé sur cette vis 26.

Dans cet exemple, la vis 26 est agencée verticalement. La tête de vis (non représentée) appuie sous la plaque 29. La tige filetée de la vis 26 passe au travers de la plaque 29, entre les extrémités 28a, 28b de la bride 27 et dépasse au dessus de ces dernières. L'écrou 25 est vissé à l'extrémité opposée à la tête de vis en contact avec des faces supérieures des extrémités 28a, 28b, de la bride 27.

Ainsi en serrant l'écrou 25, la plaque 29 se rapproche de l'écrou. De ce fait, les bords courbés verticaux 29a, 29b de la plaque 29 glissent contre les pans extérieurs obliques 28c, 28d des extrémités 28a, 28b de la bride 27. Cela entraine le rapprochement de ces dernières l'une de l'autre et donc le rétrécissement du passage 34. Lorsque la bride 27 est emmanchée sur la borne négative 4, la bride 27 se resserre donc autour de cette borne 4, assurant ainsi la fixation du capteur de courant 1 à la batterie 2.

Cette bride 27 étant électriquement conductrice, notamment en métal, elle assure également la connexion du capteur de courant 1 à la batterie 2.

Le corps de serrage 11, notamment sa bride 27, forme ainsi l'entrée d'alimentation du courant destiné à alimenter le véhicule. L'écrou 25 forme ici le moyen d'actionnement en serrage du corps de serrage 11 sur la borne négative 4.

Dans cet exemple, la borne négative 4 peut avoir une forme légèrement conique se resserrant vers le haut. La portion en arc de cercle de la bride 27 présente également des parois verticales légèrement obliques de manière à réaliser un emmanchement conique sur la borne 4. Cet emmanchement est plus simple à réaliser.

Comme l'écrou 25 est actionné en rotation autour d'un deuxième axe B vertical, correspondant ici à l'axe longitudinal B de la vis, il est possible avec l'outil d'actionnement, par exemple une visseuse, de visser cet écrou tout en appuyant sur celui-ci vers le bas. Ainsi avec une seule main et en une seule action, l'opérateur montant le capteur de courant 1 sur la batterie 2, serre le capteur de courant sur la borne 4 et le maintient vers le bas en contact avec une portion 17 de la face supérieure 7 de la batterie, évitant ainsi une remontée capteur de courant 1 vers le haut. Le montage est donc plus aisé.

Selon l'invention, vu du dessus, le capteur de courant 1 peut comprendre quatre ensembles périphériques: le moyen de serrage 20, la sortie d'alimentation 12, la sortie du signal 13, et le logement de composants électroniques 14.

Comme dans cet exemple, la sortie de signal peut être formée par un connecteur de sortie signal 13, comprenant par exemple un fût 40, surélevé au dessus du reste du capteur de courant 1. Une ouverture 41 de ce fût donne accès à une ou plusieurs broches de connexion 42, pour pouvoir amener en sortie un ou plusieurs signaux de mesure de paramètres du courant.

Ce fût peut comprendre des tenons 43, 44, pour permettre de clipper un connecteur de réception de signal de forme complémentaire.

La sortie d'alimentation 12 est ici formée par un goujon d'alimentation 12 conducteur électrique et s'étendant, ici, verticalement. Il est possible de fixer dessus ce goujon d'alimentation 12 une cosse d'un câblage de puissance, ou câble d'alimentation, par vissage vertical.

Ces ensembles périphériques peuvent être répartis autour de l'axe d'emmanchement A, en particulier autour du passage 34. Cela permet de diminuer au maximum l'encombrement du capteur de courant 1 vers l'extérieur de la batterie 2.

Par exemple, comme dans le mode de réalisation illustré, selon le sens inverse des aiguilles d'une montre, soit selon le sens trigonométrique, les ensembles périphériques peuvent être répartis autour de l'axe d'emmanchement A dans l'ordre suivant : le moyen de serrage 20, le goujon d'alimentation 12, le connecteur de sortie du signal 13, et le logement de composants électroniques 14.

Ainsi, le capteur de courant 1 peut, comme illustré, être agencé sur la borne négative 4 de la batterie 2, de manière à ce que:
- le goujon d'alimentation 12 soit au plus proche du coin supérieur arrière gauche 16 de la batterie 2 par rapport aux autres ensembles périphériques 20, 13 et 14,
- le connecteur de sortie du signal 13 soit sur le côté du capteur de courant 1 le plus proche de la face arrière 18 de la batterie 2,
- le logement de composants électroniques 14 est à l'écart des bords de la batterie 2, notamment à l'écart des faces arrière 18 et gauche 19 de la batterie 2.

Cet agencement permet de combiner différents avantages.

Comme on peut le voir en figure 7, le goujon d'alimentation 12 en étant sur le coin arrière gauche 16 de la batterie, permet une connexion à des câbles d'alimentation 46, 47, 48, 49, dans les quatre directions principales respectivement avant, gauche, arrière et droite, sans encombrement avec les autres éléments périphériques 11, 13, 14 du capteur de courant 1 et sans faire de demi-tour sur les câbles d'alimentation. La connexion en alimentation électrique des différents appareils du véhicule est ainsi simplifiée, d'autant plus que les câbles d'alimentation sont souvent de gros diamètre et donc plus durs à courber. Cela confère également une meilleure adaptabilité aux différents types de véhicules.

Par ailleurs, une fois la batterie installée, ce goujon d'alimentation 12 est au plus proche d'un accès 51 dans la paroi séparatrice 50 entre le compartiment moteur et l'habitacle. Il est donc plus aisé d'amener les câbles d'alimentation 49 en arrière de cette paroi séparatrice 50.

De plus, dans beaucoup de véhicule la batterie 2 est placée du côté de l'aile gauche. Sa position est souvent indexée sur la borne positive 3, c'est à dire par rapport au centre du véhicule. Avec une batterie 2 moins longue, le goujon d'alimentation 16 sera décalé vers le centre. Ici, cet agencement permet de rester en face de l'accès 51. Le capteur de courant 1 s'adapte donc à différentes tailles de batterie.

Également, en plaçant le connecteur de sortie de signal 13 le plus en arrière possible, cela permet de placer la batterie 2 dans un véhicule avec un capot plongeant en agençant ce connecteur de sortie de signal 13 au maximum à distance du capot plongeant.

Par ailleurs selon l'invention et comme dans l'exemple illustré, la face supérieure 7 de la batterie 2 peut comprendre autour de chacune de ses bornes 3, 4, deux épaulements perpendiculaires qui forment autour de ces bornes un espace encaissé 5, 6.

D'une manière générale selon l'invention, le capteur de courant 1 peut, comme ici, se loger dans cet espace encaissé, ici celui 6 entourant la borne négative 4. Le dessous du capteur de courant 1 est alors plaqué sur une face de contact 17 qui forme le fond de cet espace encaissé 6.

L'espace encaissé 6 est délimité à l'avant et sur la droite, respectivement par une marche avant 9b et une marche droite 9b. Ces marches, qui sont les parois verticales des deux épaulements entourant partiellement la borne négative 4, forment des murets de protection du capteur.

Or selon l'agencement du premier mode de réalisation, le logement de composants électroniques 14 se retrouve immédiatement dans l'angle de jonction de ces marches 9a et 9b et est donc protégé à l'avant et sur la droite. De plus, il est écarté au maximum des faces latérales gauche et arrière de la batterie 2. On protège ainsi les composants électroniques permettant la mesure de courant. Cela évite de les altérer lors de la pose de la batterie 2 dans le véhicule.

Le logement de composants électroniques 14 peut comprendre un boitier 10 présentant une forme complémentaire de l'angle formé par ces deux marches 9a et 9b, de manière à être calé dans cet angle une fois le capteur de courant 1 emmanché sur la borne 4.

Le capteur de courant 1, peut être circonscrit dans un rectangle horizontal. Comme on peut le voir en figure 6, les faces latérales 21, 22, 23 et 24 du capteur de courant 1 forment selon des sections horizontales une forme globalement rectangulaire. La taille du capteur de courant 1 est telle, qu'une fois logé dans l'espace encaissé 6, le capteur de courant 1 est en avant de la face arrière 18 de la batterie et à droite de la face gauche 19 de la batterie 2. De ce fait, aucune portion du capteur de courant 1 ne coupe les plans prolongeant vers le haut ces faces arrière 18 et gauche 19 de la batterie. Ainsi, le capteur de courant 1 ne risque pas d'interférer avec des éléments du compartiment moteur.

Comme on peut le voir notamment en figures 1, 2 et 5, le connecteur de sortie de signal 13 est surélevé par rapport aux autres éléments périphériques 11, 12 et 14, formant l'élément le plus haut du capteur de courant 1. En particulier, le fût 40 du connecteur de sortie de signal 13 est agencé à une distance de la surface de contact 17 supérieure à la hauteur h des marches 9a et 9b. Il est donc agencé au-dessus de l'espace encaissé 6.

De ce fait, on peut aisément y brancher un connecteur de réception du signal 15 terminant un câble de signal 45, en passant le câble par-dessus la batterie 2.

Ici l'ouverture du fût 40 et les broches 42 sont orientées vers l'avant. Cela permet un branchement depuis l'avant, donc plus facile lorsque l'on pose la batterie 2, d'autant plus lorsque, comme souvent, elle est proche de la paroi séparatrice 50. Ce connecteur de de sortie de signal 13 doit en effet être accessible pour connexion/déconnection, au cours de la durée d'utilisation de la batterie 2.

Le câble de signal 45 est généralement plus flexible que les câbles d'alimentation, et même s'il se branche depuis l'avant, il peut aisément être courbé pour revenir vers l'arrière, notamment pour passer au travers de l'accès 51.

Le connecteur de sortie de signal 13 peut être une zone connectique dites « 4 voies », notamment pour transmettre en même temps quatre signaux.

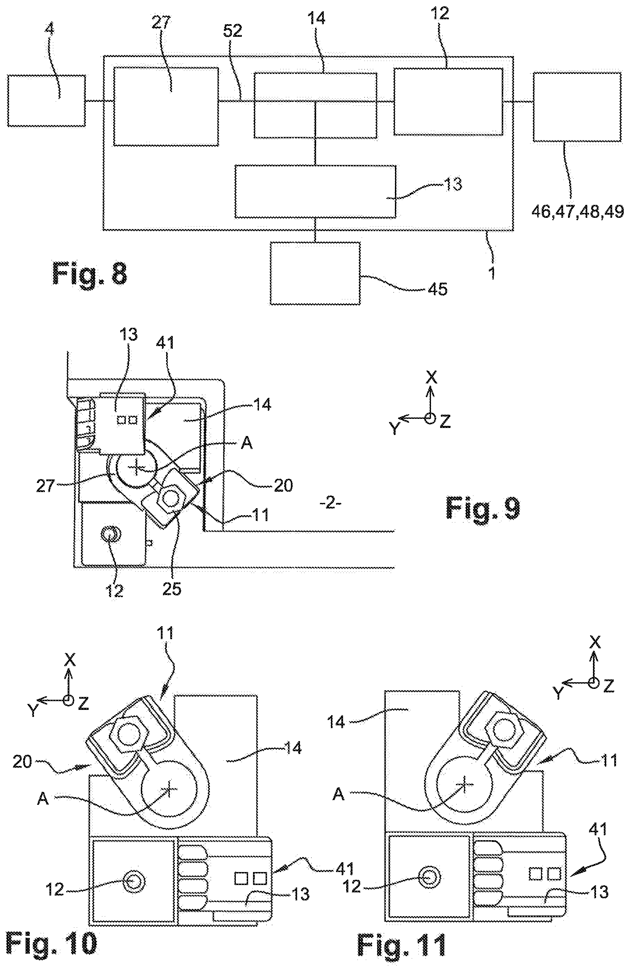

La figure 8 représente le schéma de connexion des différents éléments dans le véhicule.

La borne négative 4 est connectée électriquement à la bride de serrage 27. Cette dernière est elle-même connectée électriquement au goujon d'alimentation 12 par des conducteurs électriques 52 passant au travers du logement de composants électroniques 14. Le goujon d'alimentation 12 est lui-même connecté via des cosses aux câbles d'alimentation 46, 47, 48, 49. Ainsi, le courant d'alimentation des différents appareils du véhicule peut passer de la borne négative 4 à ces derniers via le capteur de courant 1, en particulier en passant de la bride 27 au goujon d'alimentation 12.

Dans leur logement 14, les composants électroniques sont connectés aux conducteurs électriques 52, de manière à mesurer différents paramètres du courant d'alimentation. Ces paramètres sont convertis en plusieurs signaux de mesure correspondant à différents paramètres, puis envoyés au connecteur de signal 13, d'où ils sont transmis par le câble de signal 45 à l'ordinateur de bord du véhicule. Cela peut par exemple permettre à l'ordinateur de bord de vérifier l'état de charge de la batterie 2.

Afin de prévenir tout faussement de ces mesures, il peut être utile d'empêcher l'accès à un branchement sur la borne négative 4 ou avant l'entrée du courant dans le logement de composants électroniques 14.

Par exemple, lorsque la bride 27 et la vis 26 sont en métal, la vis est donc connectée électriquement à la batterie. Afin d'éviter un branchement latéral sur la vis 26, le capteur de courant 1 comprend une enceinte de protection 30 entourant l'écrou 25 et la portion de la vis 26 au dessus de cet écrou.

Cette enceinte de protection 30 comprend ici une paroi de protection verticale 31 cylindrique agencée autour de l'écrou 25 et la portion de la vis 26 au dessus de cet écrou et sur toute leur hauteur.

L'enceinte de protection 30 comprend également un capot supérieur 32, mobile autour d'une charnière 33 et entre une position de fermeture, dans laquelle il est refermé au-dessus de la paroi de protection verticale (figure 7), et une position ouverte dans laquelle il dégage l'accès au boulon 25. Les figures 1 à 6 montrent ce capot supérieur 32 dans une position intermédiaire entre sa position de fermeture et sa position d'ouverture.

Ainsi lors du montage du capteur de courant 1 sur la batterie 2, on ouvre le capot supérieur 32, puis on effectue le serrage via le boulon 25, puis on referme le capot supérieur 32.

Comme on peut le voir en figure 7, la paroi de protection verticale 31 passe au-dessus du passage 34 et donc de la borne 4 lorsque le capteur 1 est monté sur la batterie 2. On évite ainsi également un branchement sur la borne négative 4.

L'enceinte de protection 30 permet également d'éviter les courts circuits entre l'entrée d'alimentation 11 et la sortie d'alimentation 12.

Selon l'invention, le boitier 10 du logement de composant électronique 14 peut former une seule pièce avec une, plusieurs, ou l'ensemble des parois extérieures du capteur de courant 1. Notamment, il peut former une seule pièce avec la paroi de protection verticale 31.

Le capteur de courant peut comprendre un muret de détrompage 36, situé entre le moyen de serrage 20 et le goujon d'alimentation 12. Cela permet d'éviter de mal positionner une cosse du câblage d'alimentation sur ce goujon 12 avant blocage de celle-ci, notamment par un autre écrou (non représenté).

Les figures 9 à 14 représentent d'autres modes de réalisation dans lesquels le capteur de courant comprend également les éléments périphériques suivant : un moyen de serrage 20, une sortie d'alimentation 12, une sortie du signal 13, et un logement de composants électroniques 14. Ces éléments périphériques sont individuellement similaires à ceux du premier mode de réalisation. Les mêmes références sont donc utilisées.

En revanche, ces modes de réalisation diffèrent dans l'orientation de ces éléments périphériques et également dans leur répartition par rapport à l'axe d'emmanchement A.

En figure 9 à 12 et 14, le goujon de connexion 12 est agencé comme dans le premier mode de réalisation dans le coin arrière gauche de la batterie et présente donc les mêmes avantages vis-à-vis du branchement de câbles d'alimentation.

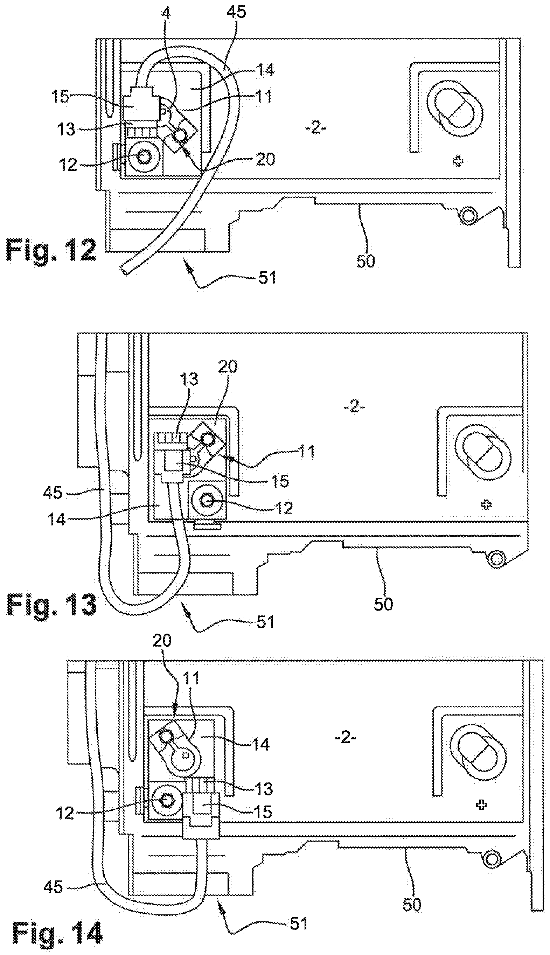

Le troisième et le septième mode de réalisation, illustrés respectivement en figures 10 et 14, sont les plus proches du premier mode de réalisation.

Le septième mode de réalisation, en figure 14, ne diffère qu'en ce que le connecteur de sortie de signal 13 s'ouvre vers l'arrière. Par conséquent, le connecteur de réception 15 du câble de signal 45 doit s'y brancher depuis l'arrière de la batterie. Ce qui est moins aisé. L'avantage est que si, contrairement à ce qui est illustré en figure 14, le câble de signal 45 doit aller vers l'habitacle moins de longueur de câble doit être utilisée.

Le troisième mode de réalisation, en figure 10, offre une solution intermédiaire, le connecteur de sortie de signal 13 s'ouvrant vers la droite. Par conséquent, le connecteur de réception du câble de signal 45 doit se brancher depuis la droite. Ce qui est moins aisé que dans le premier mode mais plus que dans le troisième.

Ces premier, troisième et septième modes de réalisation, conservent les mêmes avantages concernant les autres caractéristiques de leur agencement, notamment le connecteur de sortie de signal 13 est au plus loin du capot si celui-ci est plongeant. De plus, comme le passage 34 est légèrement excentré sur la gauche, le positionnement du moyen de serrage 20 en avant, à gauche, libère plus de place en avant à droite. Ces agencements offre donc le plus de place pour le logement de composants électroniques 14. De ce fait, ce dernier peut être plus grand et concentrer davantage composants électroniques en un même endroit, ce qui simplifie la conception de leur connexion. Par ailleurs, ces composants se retrouvent ainsi protégés par les marches de l'épaulement, lorsque la batterie 2 en est pourvue.

Le quatrième mode de réalisation, illustré en figure 11, diffère du troisième en ce que le moyen de serrage 20 est orienté sur la droite. De ce fait, il permet de protéger l'accès latéral au moyen de serrage 20, par les marches de l'épaulement, dans le cas où aucune enceinte de protection n'est prévue.

Le deuxième et le cinquième modes de réalisation, illustrés respectivement en figures 9 et 12, diffèrent des modes de réalisation décrits ci-dessus en ce que le connecteur de sortie signal 13 est en avant et à gauche dans le capteur de courant 1. Le corps de serrage 11 est orienté de sorte qu'une direction allant du passage 34 à la vis de serrage 26 est dirigée vers l'arrière et la droite.

Comparé aux modes de réalisation précédemment évoqués, l'absence de connecteur sur la droite du goujon d'alimentation 12 libère de la place sur la droite et facilite davantage le raccordement par la droite de ce goujon 12.

Le connecteur de signal 13 s'ouvre vers l'avant dans le cinquième mode de réalisation, en figure 12, ce qui facilite son branchement, comme déjà exposé plus haut. Le connecteur de signal 13 s'ouvre vers la droite dans le deuxième mode de réalisation, ce qui rend le branchement moins aisé mais nécessite moins de longueur de câbles pour aller au tableau de bord.

Dans ces deuxième et le cinquième modes de réalisation, le connecteur de signal 13 passe au-dessus du passage 34 et sert donc de moyen d'empêchement d'accès à la borne négative 4.

Cependant, en cas de capot plongeant, du fait du positionnement avant du connecteur de signal 13, celui-ci risque d'être trop proche du capot, notamment d'interférer avec la nappe-piéton, qui est la surface théorique au-dessus de laquelle un point dur, tel qu'un connecteur, peut présenter un danger pour un piéton en cas de choc. Un tel agencement reste cependant utile dans le cas d'un capot non plongeant.

Dans le sixième mode de réalisation, illustré en figure 13, le capteur de courant 1 présente un agencement dans lequel, selon le sens inverse des aiguilles d'une montre, soit selon le sens trigonométrique, les ensembles périphériques sont répartis autour de l'axe d'emmanchement A dans l'ordre suivant : le moyen de serrage 20, le connecteur de sortie du signal 13, le logement de composants électroniques 14 et le goujon d'alimentation 12, le connecteur de sortie du signal 13 s'ouvrant vers l'arrière.

Tous ces modes de réalisation, du premier au septième, présentent des avantages de robustesse et sécurité du serrage sur la borne de la batterie, grâce à l'actionnement vertical de ce serrage.

Ces différents modes de réalisation pourront être choisis lors de la conception du capteur de courant selon les véhicules auxquels ils sont destinés, en fonction de leurs avantages et de leurs inconvénients, en fonction de l'emplacement des différents appareils du véhicules devant être alimentés, et de l'emplacement du ou des dispositifs recevant le signal portant les paramètres du courant.

Le premier mode de réalisation est celui qui présente le meilleur compromis et donc la meilleure adaptabilité, quel que soit le véhicule.

En particulier, le premier mode de réalisation est le meilleur compromis en matière de :
- compatibilité avec plusieurs tailles de batterie,
- adaptation à différents environnements de véhicule.

## Revendications

1. Dispositif électronique (1) de mesure d'au moins un paramètre d'un courant électrique destiné à être monté sur une batterie (2) de véhicule, le dispositif électronique comprenant :
- une entrée d'alimentation (11) électrique et une sortie d'alimentation (12) électrique, l'entrée d'alimentation ou la sortie d'alimentation étant formée par un corps de serrage électriquement conducteur et conçu pour se resserrer autour d'un premier axe (A) vertical par l'actionnement d'un moyen de serrage (20) de manière à être apte à être serré autour d'une borne (4) de batterie s'étendant selon une direction parallèle au premier axe (A),
- une sortie d'un signal (13) portant des valeurs de mesure dudit au moins un paramètre d'un courant électrique circulant entre l'entrée d'alimentation et la sortie d'alimentation,
dans lequel le moyen de serrage (20) est agencé de manière à pouvoir être actionné par un mouvement autour ou le long d'un deuxième axe (B) sensiblement parallèle au premier axe (A), les termes "face arrière", "face longitudinale", "vertical" et "horizontal", « dessus », « supérieur », « haut », « dessous », « inférieur », « bas », « vertical », « longitudinal », « avant », « arrière », « transversal », « gauche » et « droite » étant définis par rapport à l'orientation dans laquelle le dispositif électronique est destiné à être monté sur la batterie quand ladite batterie est montée dans le véhicule reposant avec ses roues sur un sol horizontal et selon un sens de conduite en marche avant, **caractérisé en ce que** le moyen de serrage (20) comprend un moyen d'actionnement du serrage (25), ledit dispositif électronique comprenant une enceinte de protection (30) avec une ou des parois de protection verticales (31) entourant le moyen d'actionnement du serrage (25) sur toute sa hauteur, ladite enceinte de protection (30) comprend un capot supérieur (32) mobile entre une position de fermeture dans laquelle il est refermé au-dessus ou entre les parois de protection verticales, et une position ouverte dans laquelle il dégage l'accès entre ces parois verticales de protection.

2. Dispositif électronique (1) selon la revendication 1, dans lequel la sortie du signal est formée par un connecteur (13), ce connecteur (13) étant décalé vers le haut par rapport à l'entrée d'alimentation (11) et à la sortie d'alimentation (12).

3. Dispositif électronique (1) selon l'une des revendications précédentes, dans lequel le dispositif électronique comprend des bords latéraux (21, 22, 23, 24) circonscrits globalement dans un rectangle.

4. Dispositif électronique (1) selon l'une des revendications précédentes, comprenant un logement de composants électroniques (14), et dans lequel, vu du côté où le moyen de serrage (20) est actionnable, le moyen de serrage (20), la sortie d'alimentation (12), la sortie du signal (13), et le logement de composants électroniques (14) sont répartis dans cet ordre autour du premier axe (A) selon le sens inverse des aiguilles d'une montre.

5. Dispositif électronique (1) selon l'une quelconque des revendications précédentes, dans lequel le corps de serrage (11) comprend une bride (27) en forme de U dans une section perpendiculaire au premier axe (A), cette forme en U comprenant une portion en arc de cercle et deux extrémités (28a, 28b), la portion en arc de cercle définissant un passage (34) destiné à s'emmancher sur l'une des bornes de la batterie (2),
et dans lequel le moyen de serrage (20) comprend une vis (26), un écrou (24) monté sur la vis et une contreforme (29) solidaire de la vis, la vis étant agencée selon le deuxième axe (B) et passant entre les extrémités de la forme en U, et l'écrou et la contreforme étant agencés selon le deuxième axe de part et d'autre de ces extrémités, ces extrémités (28a, 28b) et la contreforme (29) présentant des formes complémentaires s'engageant l'une par rapport à l'autre de manière à ce qu'un effort de vissage sur l'écrou soit transféré en un effort sensiblement perpendiculaire audit deuxième axe (B) de manière à rapprocher les extrémités de le forme en U l'une de l'autre.

6. Dispositif électronique (1) selon l'une quelconque des revendications précédentes, dans lequel le moyen de serrage (20) comprend un passage (34) pour une borne (4) de batterie (2), l'actionnement en serrage du moyen de serrage (13) réduisant ce passage, ladite enceinte de protection (30) passant au-dessus de ce passage.

7. Batterie (2) de véhicule comprenant un dispositif électronique (1) selon l'une des revendications précédentes, ledit dispositif électronique étant monté sur ladite batterie, le corps de serrage (11) étant serré autour de l'une des bornes (4) de la batterie.

8. Véhicule (1) comprenant une batterie selon la revendication 7.

## Patentansprüche

1. Elektronische Vorrichtung (1) zum Messen mindestens eines Parameters eines elektrischen Stroms, die dazu bestimmt ist, an einer Fahrzeugbatterie (2) angebracht zu werden, wobei die elektronische Vorrichtung Folgendes aufweist:
- einen Stromversorgungseingang (11) und einen Stromversorgungsausgang (12), wobei der Stromversorgungseingang oder der Stromversorgungsausgang durch einen elektrisch leitenden Klemmkörper gebildet wird, der so ausgelegt ist, dass er sich durch Betätigung eines Klemmmittels (20) um eine erste vertikale Achse (A) zusammenzieht, sodass er um einen Batteriepol (4) geklemmt werden kann, der sich in einer zur ersten Achse (A) parallelen Richtung erstreckt,
- einen Ausgang eines Signals (13), das Messwerte des mindestens einen Parameters eines zwischen dem Stromversorgungseingang und dem Stromversorgungsausgang fließenden elektrischen Stroms trägt,
wobei das Klemmmittel (20) so angeordnet ist, dass es durch eine Bewegung um oder entlang einer zweiten Achse (B) betätigt werden kann, die im Wesentlichen parallel zur ersten Achse (A) verläuft, wobei die Begriffe "Rückseite", "Längsseite", "vertikal" und "horizontal", "über", "höher", "oben", "unter", "niedriger", "unten", "vertikal", "längs", "vorn", "hinten", "quer", "links" und "rechts" in Bezug auf die Ausrichtung definiert sind, in der die elektronische Vorrichtung an der Batterie montiert werden soll, wenn die Batterie in dem Fahrzeug montiert ist, das mit seinen Rädern auf einem horizontalen Boden steht und in Vorwärtsfahrtrichtung fährt, **dadurch gekennzeichnet, dass** das Klemmmittel (20) eine Betätigungsvorrichtung für die Klemmung (25) aufweist, wobei die elektronische Vorrichtung ein Schutzgehäuse (30) mit einer oder mehreren vertikalen Schutzwänden (31) aufweist, die die Betätigungsvorrichtung für die Klemmung (25) über ihre gesamte Höhe umgeben,
wobei das Schutzgehäuse (30) eine obere Abdeckung (32) aufweist, die zwischen einer geschlossenen Position, in der sie über oder zwischen den vertikalen Schutzwänden geschlossen ist, und einer offenen Position, in der sie den Zugang zwischen diesen vertikalen Schutzwänden freigibt, beweglich ist.

2. Elektronische Vorrichtung (1) nach Anspruch 1, wobei der Signalausgang durch einen Stecker (13) gebildet wird, wobei dieser Stecker (13) gegenüber dem Stromversorgungseingang (11) und dem Stromversorgungsausgang (12) nach oben versetzt ist.

3. Elektronische Vorrichtung (1) nach einem der vorhergehenden Ansprüche, wobei die elektronische Vorrichtung Seitenkanten (21, 22, 23, 24) aufweist, die im Wesentlichen von einem Rechteck umschlossen sind.

4. Elektronische Vorrichtung (1) nach einem der vorhergehenden Ansprüche mit einem Gehäuse für elektronische Bauteile (14), bei dem, von der Seite aus gesehen, auf der das Klemmmittel (20) betätigt werden kann, das Klemmmittel (20), der Stromversorgungsausgang (12), der Signalausgang (13) und das Gehäuse für elektronische Bauteile (14) in dieser Reihenfolge um die erste Achse (A) gegen den Uhrzeigersinn angeordnet sind.

5. Elektronische Vorrichtung (1) nach einem der vorhergehenden Ansprüche, wobei der Klemmkörper (11) einen Flansch (27) in U-Form in einem Querschnitt senkrecht zur ersten Achse (A) aufweist, wobei diese U-Form einen bogenförmigen Abschnitt und zwei Enden (28a, 28b) aufweist, wobei der bogenförmige Abschnitt einen Durchgang (34) zum Aufstecken auf einen der Pole der Batterie (2) bildet,
und wobei das Klemmmittel (20) eine Schraube (26), eine auf der Schraube montierte Mutter (24) und eine mit der Schraube verbundene Gegenform (29) aufweist, wobei die Schraube entlang der zweiten Achse (B) angeordnet ist und zwischen den Enden der U-Form verläuft und die Mutter und die Gegenform entlang der zweiten Achse auf beiden Seiten dieser Enden angeordnet sind, wobei diese Enden (28a, 28b) und die Gegenform (29) komplementäre Formen aufweisen, die so ineinander greifen, dass eine auf die Mutter ausgeübte Schraubkraft in eine Kraft umgewandelt wird, die im Wesentlichen senkrecht zur zweiten Achse (B) steht, um die Enden der U-Form einander anzunähern.

6. Elektronische Vorrichtung (1) nach einem der vorhergehenden Ansprüche, wobei die Klemmvorrichtung (20) einen Durchgang (34) für einen Anschluss (4) einer Batterie (2) aufweist, wobei die Klemmbetätigung der Klemmvorrichtung (13) diesen Durchgang verkleinert und das Schutzgehäuse (30) oberhalb dieses Durchgangs verläuft.

7. Fahrzeugbatterie (2) mit einer elektronischen Vorrichtung (1) nach einem der vorhergehenden Ansprüche, wobei die elektronische Vorrichtung an der Batterie angebracht ist und der Klemmkörper (11) um einen der Pole (4) der Batterie geklemmt ist.

8. Fahrzeug (1) mit einer Batterie nach Anspruch 7.

## Claims

1. Electronic device (1) for measuring at least one parameter of an electric current intended to be mounted on a vehicle battery (2), the electronic device comprising:
- an electrical power supply input (11) and an electrical power supply output (12), the power supply input or the power supply output being formed by an electrically conductive fastening body designed to be tightened around a first vertical axis (A) by the actuation of a fastening means (20), so as to be capable of being fastened around a battery terminal (4) extending in a direction parallel to the first axis (A),
- an output of a signal (13) carrying measured values of said at least one parameter of an electric current flowing between the power supply input and the power supply output,
wherein the fastening means (20) is arranged so that it can be actuated by a movement around or along a second axis (B) substantially parallel to the first axis (A), the terms "rear face", "longitudinal face", "vertical" and "horizontal", "above", "upper", "top", "below", "lower", "bottom", "vertical", "longitudinal", "front", "rear", "transverse", "left" and "right" being defined with respect to the orientation in which the electronic device is intended to be mounted on the battery when said battery is mounted in the vehicle resting on its wheels on a horizontal ground surface and oriented in the forward driving direction, **characterized in that** the fastening means (20) comprises a fastening actuation means (25), said electronic device comprising a protective enclosure (30) with one or more vertical protecting walls (31) surrounding the fastening actuation means (25) over the whole of its height,
said protective enclosure (30) comprises an upper cover (32) which is movable between a closed position in which it is closed above or between the vertical protecting walls, and an open position in which it allows free access between these vertical protecting walls.

2. Electronic device (1) according to Claim 1, wherein the signal output is formed by a connector (13), this connector (13) being offset upwards relative to the power supply input (11) and the power supply output (12).

3. Electronic device (1) according to either of the preceding claims, wherein the electronic device comprises lateral edges (21, 22, 23, 24) completely contained within a rectangle.

4. Electronic device (1) according to any of the preceding claims, comprising a housing for electronic components (14), and wherein, when viewed from the side where the fastening means (20) can be actuated, the fastening means (20), the power supply output (12), the signal output (13), and the electronic component housing (14) are distributed in this order around the first axis (A) in an anti-clockwise direction.

5. Electronic device (1) according to any one of the preceding claims, wherein the fastening body (11) comprises a clamp (27) which is U-shaped in a cross section perpendicular to the first axis (A), this U shape comprising a portion forming an arc of a circle and two ends (28a, 28b), the portion forming an arc of a circle defining a passage (34) intended to be fitted on to one of the terminals of the battery (2),
and wherein the fastening means (20) comprises a screw (26), a nut (24) mounted on the screw and a counter-shape (29) attached to the screw, the screw being arranged along the second axis (B) and passing between the ends of the U shape, and the nut and the counter-shape being arranged along the second axis on either side of these ends, these ends (28a, 28b) and the counter-shape (29) having complementary shapes engaging with one another so that a screwing force on the nut is transferred into a force substantially perpendicular to said second axis (B), so as to bring the ends of the U shape towards one another.

6. Electronic device (1) according to any one of the preceding claims, wherein the fastening means (20) comprises a passage (34) for a terminal (4) of a battery (2), the fastening actuation of the fastening means (13) narrowing this passage, said protective enclosure (30) passing above this passage.

7. Vehicle battery (2) comprising an electronic device (1) according to any of the preceding claims, said electronic device being mounted on said battery, the fastening body (11) being fastened around one of the terminals (4) of the battery.

8. Vehicle (1) comprising a battery according to Claim 7.
